# EUROPÄISCHE PATENTSCHRIFT

(11) **EP 2 702 844 B1**
(45) Veröffentlichungstag und Bekanntmachung des Hinweises auf die Patenterteilung: **21.03.2018**
(21) Anmeldenummer: 11717572.9
(22) Anmeldetag: 27.04.2011
(51) Int. Cl.: H05K 5/06, H05K 5/00

(54) **GEHÄUSEEINHEIT FÜR ELEKTRISCHE KOMPONENTEN ZUM EINSATZ IM KRAFTFAHRZEUGBEREICH**
HOUSING UNIT FOR ELECTRICAL COMPONENTS FOR USE IN THE AUTOMOBILE SECTOR
ENSEMBLE BOÎTIER POUR COMPOSANTS ÉLECTRIQUES DESTINÉ À ÊTRE UTILISÉ DANS LE DOMAINE DE L'AUTOMOBILE

(43) Veröffentlichungstag der Anmeldung: 05.03.2014
(73) Patentinhaber: Pierburg Pump Technology GmbH, 41460 Neuss (DE)
(72) Erfinder: RATHKE, Ronald, 04720 Döbeln (DE); WEINERT, Michael, 04703 Leisnig (DE); ZACHER, Wolfgang, 04720 Döbeln (DE); PATZNER, René, 09337 Hohenstein-Ernstthal (DE)
(74) Vertreter: Patentanwälte ter Smitten Eberlein-Van Hoof Rütten Partnerschaftsgesellschaft mbB
(86) Internationale Anmeldenummer: PCT/EP2011/056615
(87) Internationale Veröffentlichungsnummer: WO 2012/146275

(56) Entgegenhaltungen:
- EP-A1- 1 784 066
- EP-A2- 1 313 359
- WO-A1-88/09422
- WO-A1-99/29150
- DE-A1-102004 056 662
- DE-C1- 19 544 974

## Beschreibung

Die Erfindung betrifft eine Gehäuseeinheit für elektrische Komponenten einer Wasserumwälzpumpe zum Einsatz im Kraftfahrzeugbereich, mit einem Gehäuseteil, das durch eine Gehäusedeckelanordnung abgedichtet verschließbar ist, wobei die Gehäusedeckelanordnung ein Deckelgrundelement mit einer Vertiefung aufweist, wobei in der Vertiefung eine Öffnung vorgesehen ist, die durch eine Membrane abgedichtet verschließbar ist, wobei ein Deckelabschlusselement vorgesehen ist, das die Vertiefung mit der mindestens einen Entlüftungsöffnung abschließt.

Derartige Gehäuseeinheiten für elektrische Komponenten sind aus dem Stand der Technik bekannt. So offenbart die EP 0 113 073 A1 eine Gehäuseeinheit mit einem Gehäuseteil, das eine elektrische Schaltung aufnimmt, durch eine Membrane gegen Feuchtigkeit geschützt ist und durch einen Deckel, der dem mechanischen Schutz der Membrane dient, abgedichtet abgeschlossen ist. Um im Gehäuse einen Druckausgleich vorzusehen, und auf diese Art und Weise auf Temperaturänderungen und/oder Änderungen des Außendrucks reagieren zu können, ist eine Entlüftungsbohrung im Deckel vorgesehen. Eine derartig aufgebaute Gehäuseeinheit weist den Nachteil auf, dass die Membrane sich bei einem nachfolgenden Fügeprozess des Deckels, beispielsweise durch Ultraschweißen, löst und so die elektrischen Komponenten in jedem Fall wieder der Feuchtigkeit ausgesetzt sind. Aus der EP 1 784 066 A1 ist eine Gehäuseeinheit für elektronische Komponenten bekannt, bei der ein Deckelgrundelement mit einer Membrane und einem Deckelabschlusselement als Einsatzteil ausgebildet ist und abgedichtet kraftschlüssig in eine Öffnung eingesetzt ist. Die WO 88/00268 offenbart eine gattungsgemäße Gehäuseeinheit für eine Wasserumwälzpumpe für den Kraftfahrzeugbereich. Alle Gehäuseeinheiten weisen den Nachteil auf, dass sie nicht für den Einsatz im Kraftfahrzeugbereich geeignet und/oder zu aufwendig und kompliziert in der Herstellung sind.

Es ist daher Aufgabe der Erfindung, eine Gehäuseeinheit für elektrische Komponenten bereitzustellen, die auf kostengünstige Art und Weise die oben genannten Nachteile vermeiden.

Diese Aufgabe wird dadurch gelöst, die Öffnung eine Rippenanordnung aufweist, die die Membrane vorspannt, wobei die Vertiefung trichterförmig ausgebildet ist und wobei das Deckelabschlusselement einen geringeren Durchmesser aufweist als der größte Durchmesser der Vertiefung und mit Auflageelementen der Vertiefung stoffschlüssig verbunden ist, derart, dass im Umfangsbereich des Deckelabschlusselementes Entlüftungsöffnungen vorgesehen sind. Dadurch, dass in der Öffnung der Vertiefung des Deckelgrundelementes eine Rippenanordnung vorgesehen ist, die die Membrane vorspannt, wird ein Flattern oder Schlagen der Membrane bei einem Fügeprozess, beispielsweise Ultraschallschweißen des Deckelabschlusselementes oder der Gehäusedeckelanordnung verhindert und damit gewährleistet, dass die Membrane einwandfrei und abgedichtet befestigt ist.Dadurch, dass das Deckelabschlusselement einen geringeren Durchmesser aufweist als der größte Durchmesser der Vertiefung und über Auflageelemente in der Vertiefung stoffschlüssig angeordnet ist, ist eine besonders einfache und sichere Montage möglich und werden automatisch im Umfangsbereich des Deckelabschlusselementes Entlüftungsöffnungen gebildet. Hierdurch wird auf einfache Weise gewährleistet, dass Feuchtigkeit oder Wasserdampf aus dem Bereich der Gehäuseeinheit abfließen bzw. verdunsten kann.

In montagetechnischer Hinsicht kann es sehr vorteilhaft sein, wenn das Deckelgrundelement Zentrierelemente für das Deckelabschlusselement aufweist. Vorteilhafterweise ist die Rippenanordnung sternförmig ausgebildet.

Ein Ausführungsbeispiel der Erfindung wird in der Zeichnung dargestellt. Hierin zeigt:
- Figur 1: eine perspektivische Ansicht einer Kfz-Wasserumwälzpumpe mit abgehobenem Deckel;
- Figur 2: eine Schnittansicht durch die Gehäuseeinheit für elektrische Komponenten der Wasserumwälzpumpe.

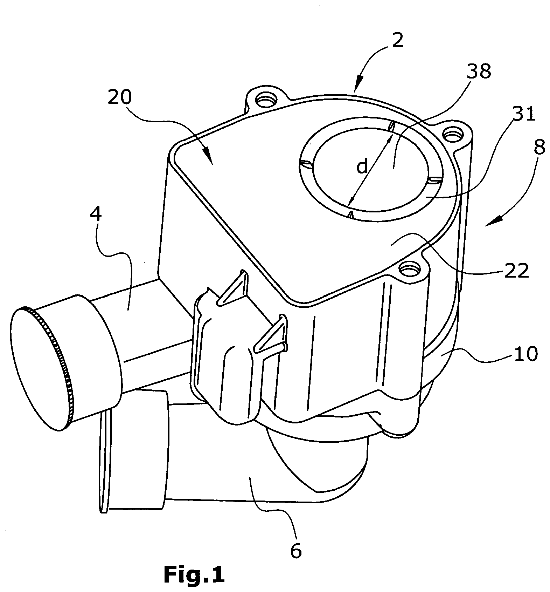

Figur 1 zeigt eine perspektivische Ansicht einer Wasserumwälzpumpe 2 mit einem Einlassstutzen 4 und einem Auslassstutzen 6. Des Weiteren ist eine Gehäuseeinheit 8 vorgesehen, an die sich ein Pumpenwerk 10 anschließt, das wiederum auf bekannte Weise mit dem Einlassstutzen 4 und dem Auslassstutzen 6 verbunden ist.

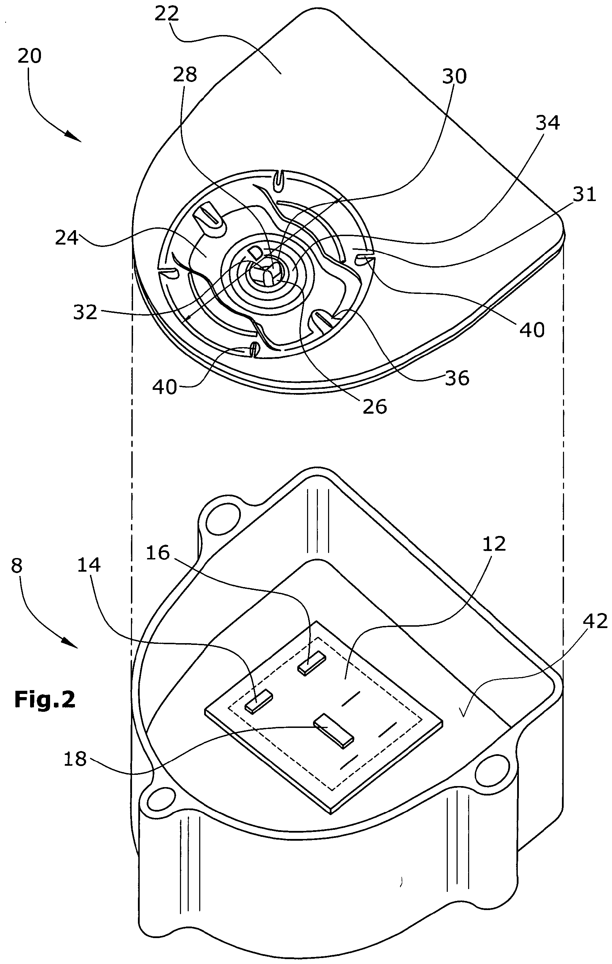

Das Gehäuseteil 8 weist eine Platine 12 mit elektrischen Komponenten 14, 16, 18 auf (siehe Figur 2), die der Steuerung der Wasserumwälzpumpe dienen. Das Gehäuseteil 8 ist durch eine Gehäusedeckelanordnung 20 abgedichtet verschließbar. Erfindungsgemäß besteht die Gehäusedeckelanordnung 20 aus einem Deckelgrundelement 22, das eine Vertiefung 24 besitzt. Die Vertiefung 24 ist trichterförmig ausgebildet, damit in der Vertiefung 24 befindliches Wasser in jeder Einbaulage abfließen kann. Des Weiteren weist die Vertiefung 24 eine Öffnung 26 mit einer sternförmigen Rippenanordnung 28 auf, die gegenüber der Öffnungsumfangsfläche 30 derart zum Mittelpunkt der Öffnung 32 erhöht ist, dass eine Membrane 34, die die Öffnung 26 abschließt, vorgespannt ist. Durch diese Vorspannung der Membrane 34 wird ein Flattern oder Schlagen bei einem nachfolgenden Fügeprozess, beispielsweise durch Ultraschallschweißen, verhindert und auf diese Weise sichergestellt, dass die Membrane beim Fügeprozess nicht beschädigt wird. Des Weiteren weist die Vertiefung 24 Auflageelemente 36 auf, die jeweils eine Rippe besitzen zur stoffschlüssigen Verbindung mittels Ultraschallschweißen mit einem Deckelabschlusselement 38. Der Durchmesser des Deckelabschlusselementes d ist hierbei kleiner als der größte Durchmesser D der Vertiefung des Deckelgrundelementes 22. Auf diese Weise wird quasi eine Entlüftungsöffnung 31 über den gesamten Umfangsbereich des Deckelabschlusselementes 38 geschaffen, wodurch in jeder Einbaulage auf einfache Weise Flüssigkeit aus der Vertiefung 24 abfließen kann. Zur einfachen Montage des Deckelabschlusselementes 38 sind Zentrierelemente 40 vorgesehen, durch die die Einbaulage des Deckelabschlusselementes 38 im Montagezustand definiert ist.

Durch eine derartige Anordnung wird auf einfache Weise gewährleistet, dass ein Druckausgleich bei Temperaturänderungen und/oder Änderungen des Außendruckes im Gehäuseteil mit der Platine 12 sowie den elektrischen Komponenten 14 bis 18 stattfinden kann. Die Membrane ist durch das Deckelabschlusselement 38 gegen eine mechanische Einwirkung geschützt. Ein Abtransport von Flüssigkeit oder Wasserdampf ist in jeder Einbaulage gewährleistet.

Figur 2 zeigt eine Schnittansicht der Gehäuseeinheit 8. Deutlich zu erkennen ist hier die Anordnung der Platine 12 mit den elektrischen Komponenten 14, 16 und 18. Der Raum 42, in dem sich die Platine 12 und die elektrischen Komponenten 14, 16 und 18 befinden, wird durch das Deckelgrundelement 20 mit der Membrane 34 abgedichtet verschlossen.

Deutlich zu erkennen ist in diesem Zusammenhang auch die Erhöhung der Rippenanordnung, die zu einer regenschirmförmigen Aufspannung der Membrane 34 führt. Die Vertiefung wird wie oben beschrieben durch das Deckelabschlusselement 38 abgeschlossen. Durch den geringeren Durchmesser d des Deckelabschlusselementes 38 ergeben sich zwangsläufig umfangsseitige Entlüftungsöffnungen 31.

## Patentansprüche

1. Gehäuseeinheit für elektrische Komponenten einer Wasserumwälzpumpe (2) zum Einsatz im Kraftfahrzeugbereich, mit einem Gehäuseteil (8), das durch eine Gehäusedeckelanordnung (20) abgedichtet verschließbar ist, wobei die Gehäusedeckelanordnung ein Deckelgrundelement (22) mit einer Vertiefung (24) aufweist, wobei in der Vertiefung eine Öffnung (26) vorgesehen ist, die durch eine Membrane (34) abgedichtet verschließbar ist, wobei ein Deckelabschlusselement vorgesehen ist, das die Vertiefung mit der mindestens einen Entlüftungsöffnung (31) abschließt, **dadurch gekennzeichnet, dass** die Öffnung (26) eine Rippenanordnung (28) aufweist, die die Membrane (34) vorspannt, wobei die Vertiefung (24) trichterförmig ausgebildet ist und wobei das Deckelabschlusselement (38) einen geringeren Durchmesser aufweist als der größte Durchmesser der Vertiefung (24) und mit Auflageelementen (36) der Vertiefung (24) stoffschlüssig verbunden ist, derart, dass im Umfangsbereich des Deckelabschlusselementes (38) Entlüftungsöffnungen (31) vorgesehen sind.

2. Gehäuseeinheit nach Anspruch 1, **dadurch gekennzeichnet, dass** das Deckelgrundelement (22) Zentrierelemente (40) für das Deckelabschlusselement (38) aufweist.

3. Gehäuseeinheit nach Anspruch 1 oder 2, **dadurch gekennzeichnet, dass** die Rippenanordnung (28) sternförmig ausgebildet ist.

## Claims

1. A housing unit for electrical components of a water circulating pump (2) for use in the automobile sector, comprising
a housing part (8) configured to be closed in a sealed manner by a housing cover arrangement (20), the housing cover arrangement (20) comprising a main cover element (22) comprising a recess (24), the recess comprising an opening (26) which is configured to be closed in a sealed manner by a membrane (34), wherein a cover closure element is provided to close the recess with the at least one ventilation opening (31),
**characterized in that**
the opening (26) comprises a rib arrangement (28) which pretensions the membrane (34), wherein the recess (24) is funnel-shaped, and wherein the diameter of the cover closure element (38) is smaller than the largest diameter of the recess (24), and the cover closure element is materially bonded with support elements (36) of the recess (24) so as to provide ventilation openings (31) in the circumferential zone of the cover closure element (38).

2. The housing unit as recited in claim 1, **characterized in that** the main cover element (22) comprises centering elements (40) for the cover closure element (38).

3. The housing unit as recited in claim 1 or 2, **characterized in that** the rib arrangement (28) is star-shaped.

## Revendications

1. Ensemble boitier pour composants électriques pour pompe de circulation de l'eau (2), destiné à être utilisé dans le domaine de l'automobile, comprenant
une partie de boitier (8) pouvant être fermée de manière étanche par un ensemble couvercle de boitier (20), ledit ensemble couvercle de boitier comprenant un élément de base de couvercle (22) avec un renfoncement (24), le renfoncement étant pourvu d'une ouverture (26) pouvant être fermée de manière étanche par une membrane (34), un élément de fermeture du couvercle étant prévu fermant le renfoncement avec la au moins une ouverture de ventilation (31),
**caractérisé en ce que**
ladite ouverture (26) présente un ensemble de nervures (28) sollicitant la membrane (34), le renfoncement (24) étant en forme d'entonnoir, et ledit élément de fermeture du couvercle (38) ayant un diamètre inférieur au diamètre maximal du renfoncement (24) et étant en liaison matérielle avec des éléments de support (36) du renfoncement (24), de sorte que des ouvertures de ventilation (31) sont prévues dans la région circonférentielle dudit élément de fermeture du couvercle (38).

2. Ensemble boitier selon la revendication 1, **caractérisé en ce que** ledit élément de base de couvercle (22) comprend des éléments de centrage (40) pour ledit élément de fermeture du couvercle (38).

3. Ensemble boitier selon l'une des revendications 1 ou 2, **caractérisé en ce que** ledit ensemble de nervures (28) est conçu en étoile.
